# EUROPEAN PATENT APPLICATION

(11) **EP 4 845 324 A1**
(43) Date of publication of application: **25.11.2026**
(21) Application number: 26180281.3
(22) Date of filing: 21.05.2026
(51) Int. Cl.: H05K 7/20

(54) **IMMERSION COOLING SYSTEM AND METHOD FOR CONTROLLING THE SAME**

(30) Priority: 21.05.2025 KR 20250066236; 20.05.2026 KR 20260091283
(71) Applicant: SK Innovation Co., Ltd., Seoul 03188 (KR); SK On Co., Ltd., Seoul 03161 (KR)
(72) Inventor: KWON, Dong Jae, 34124 Daejeon (KR); YOO, Dong Kyun, 34124 Daejeon (KR); JO, Woo Young, 34124 Daejeon (KR)
(74) Representative: Prüfer & Partner mbB Patentanwälte · Rechtsanwälte

(57) **Abstract**

The present disclosure relates to an immersion cooling system (1000, 2000, 3000) and a method for controlling the same. An immersion cooling system (1000, 2000, 3000) includes an immersion cooling chamber (500, 500a, 500b) accommodating at least one heat source; a plurality of reservoirs (100, 200) respectively storing a coolant; a flow path control device (300, 300a) connected to the plurality of reservoirs (100, 200) and configured to control a flow path such that a coolant stored in one of the plurality of reservoirs (100, 200) is provided to the immersion cooling chamber (500, 500a, 500b); and a controller (400) configured to receive, from at least one temperature sensor, a temperature of the immersion cooling chamber (500, 500a, 500b) or the at least one heat source, determine, based on the received temperature, a coolant to be provided to the immersion cooling chamber (500, 500a, 500b), and control the flow path control device such that the determined coolant is provided to the immersion cooling chamber (500, 500a, 500b).

## Description

### BACKGROUND

### Technical Field

The present disclosure relates to an immersion cooling system and a method for controlling the same.

### Technical Considerations

With the development of advanced technologies such as the Internet of Things (IoT), artificial intelligence (AI), fifth-generation (5G) mobile communication, and streaming technology, the development of high-performance chips (e.g., integrated circuits (ICs)) has been accelerated. Although such high-performance chips have high integration density and processing speed to improve computational capability, they also have a problem in that the amount of heat generated increases accordingly. For example, in a high-density chip structure, heat dissipation is limited, thereby causing an overheating problem, which may lead to degradation in system performance and reliability.

Immersion cooling technology has recently attracted increasing attention as a technique for solving a heat generation problem of high-performance chips, and may efficiently remove heat by immersing a substrate on which a high-performance chip is mounted in a non-conductive or dielectric cooling fluid. Recently, systems applying immersion cooling technology, which provides higher cooling efficiency than an air-cooling scheme, have been increasingly used to manage heat generated by highly integrated computing equipment included in servers, data centers, and the like. However, currently widely used cooling fluids may be unable to suppress a fire caused by generation of a large amount of heat. Accordingly, there is a need for a technique capable of improving the safety of an immersion cooling system.

### SUMMARY

According to an aspect of the present disclosure, an immersion cooling system and a method for controlling the same may be provided, capable of improving safety.

According to another aspect of the present disclosure an immersion cooling system and a method for controlling the same may be provided, capable of improving cost.

According to an aspect of the present disclosure, there is provided an immersion cooling system, the system comprising: an immersion cooling chamber configured to accommodate at least one first heat source; a plurality of reservoirs configured to respectively store a coolant; a flow path control device connected to the plurality of reservoirs and configured to control a flow path such that a coolant stored in one of the plurality of reservoirs is provided to the immersion cooling chamber; and a controller configured to receive, from at least one temperature sensor, a temperature of the immersion cooling chamber or the at least one first heat source, determine, based on the received temperature, a coolant to be provided to the immersion cooling chamber, and control the flow path control device such that the determined coolant is provided to the immersion cooling chamber.

In some non-limiting embodiments, the plurality of reservoirs may comprise: a first reservoir configured to store a first coolant; and a second reservoir configured to store a second coolant different from the first coolant.

In some non-limiting embodiments, the controller may determine whether the received temperature is lower than a predetermined reference temperature, control the flow path control device such that the first reservoir is connected to the immersion cooling chamber when the received temperature is lower than the reference temperature, and control the flow path control device such that the second reservoir is connected to the immersion cooling chamber when the received temperature is equal to or greater than the reference temperature.

In some non-limiting embodiments, the first coolant may comprise a cooling fluid suitable for cooling below the reference temperature, and the second coolant may comprise a cooling fluid or an additive suitable for cooling at or above the reference temperature or for fire suppression.

In some non-limiting embodiments, the plurality of reservoirs may further comprise a third reservoir configured to store a third coolant different from the first coolant and the second coolant. The first coolant may comprise a cooling fluid suitable for cooling below a predetermined first reference temperature, the second coolant may comprise a cooling fluid or an additive suitable for cooling below a second reference temperature greater than the first reference temperature, and the third coolant may comprise a cooling fluid or an additive suitable for cooling at or above the second reference temperature or for fire suppression.

In some non-limiting embodiments, the at least one temperature sensor may be located at at least one of an exterior of the immersion cooling chamber and an interior of the immersion cooling chamber.

In some non-limiting embodiments, the flow path control device may comprise a multi-way valve.

In some non-limiting embodiments, the immersion cooling system may further comprise a heat exchanger located between the flow path control device and the immersion cooling chamber and configured to cool a coolant provided to the immersion cooling chamber.

In some non-limiting embodiments, the at least one first heat source may comprise at least one of an electronic board including at least one electronic component, an electronic device, or a secondary battery.

In some non-limiting embodiments, the immersion cooling system may further comprise at least one additional immersion cooling chamber configured to accommodate at least one second heat source and share the plurality of reservoirs with the immersion cooling chamber.

In some non-limiting embodiments, the controller may comprise: a sensor module including the at least one temperature sensor; a processor configured to generate a flow path control command for controlling the flow path control device such that one of the plurality of reservoirs is connected to the immersion cooling chamber based on a temperature obtained through the at least one temperature sensor included in the sensor module; and a communication module configured to transmit the flow path control command to the flow path control device.

In some non-limiting embodiments, the controller may further comprise a memory configured to store a mapping table including at least one reference temperature for determining the coolant.

According to another aspect of the present disclosure, there is provided a method for controlling an immersion cooling system, the method comprising: detecting, through at least one temperature sensor heat source, a temperature of an immersion cooling chamber or at least one heat source included in the immersion cooling chamber; determining, based on the detected temperature, a coolant to be provided to the immersion cooling chamber; and performing immersion cooling by providing the determined coolant to the immersion cooling chamber.

In some non-limiting embodiments, performing immersion cooling may comprise providing, to the immersion cooling chamber, the determined coolant by controlling a flow path control device configured to control a flow path between the immersion cooling chamber and a plurality of reservoirs configured to respectively store a coolant.

In some non-limiting embodiments, the providing may comprise: generating a flow path control command for controlling the flow path control device such that one of the plurality of reservoirs storing the determined coolant is connected to the immersion cooling chamber; and transmitting the flow path control command to the flow path control device.

In some non-limiting embodiments, determining the coolant may comprise determining, based on the detected temperature while the immersion cooling chamber contains a first coolant, whether to maintain the first coolant in the immersion cooling chamber or to provide, to the immersion cooling chamber, a second coolant different from the first coolant.

In some non-limiting embodiments, determining the coolant may comprise: determining whether the detected temperature is lower than a predetermined reference temperature; selecting the first coolant when the detected temperature is lower than the reference temperature; and selecting the second coolant when the detected temperature is equal to or greater than the reference temperature.

In some non-limiting embodiments, performing the immersion cooling may comprise: controlling the flow path control device such that a first reservoir configured to store a first coolant is connected to the immersion cooling chamber when the detected temperature is lower than a predetermined reference temperature; and controlling the flow path control device such that a second reservoir configured to store a second coolant different from the first coolant is connected to the immersion cooling chamber when the detected temperature is equal to or greater than the reference temperature.

In some non-limiting embodiments, the plurality of reservoirs may comprise a first reservoir configured to store a first coolant and a second reservoir configured to store a second coolant different from the first coolant. The first coolant may comprise a cooling fluid suitable for cooling below a predetermined reference temperature, and the second coolant may comprise a cooling fluid or an additive suitable for cooling at or above the reference temperature or for fire suppression.

In some non-limiting embodiments, the plurality of reservoirs may comprise a first reservoir configured to store a first coolant, a second reservoir configured to store a second coolant different from the first coolant, and a third reservoir configured to store a third coolant different from the first coolant and the second coolant. The first coolant may comprise a cooling fluid suitable for cooling below a predetermined first reference temperature, the second coolant may comprise a cooling fluid or an additive suitable for cooling below a second reference temperature greater than the first reference temperature, and the third coolant may comprise a cooling fluid or an additive suitable for cooling at or above the second reference temperature or for fire suppression.

### BRIEF DESCRIPTION OF THE DRAWINGS

The above and other objects, features and other advantages of the present disclosure will be more clearly understood from the following detailed description taken in conjunction with the accompanying drawings, in which:
FIG. 1 is a diagram illustrating an immersion cooling system according to an embodiment of the present disclosure.
FIG. 2 is a diagram illustrating the immersion cooling chamber of FIG. 1.
FIG. 3 is a block diagram illustrating a configuration of a controller according to an embodiment of the present disclosure.
FIG. 4A is a diagram illustrating an immersion cooling system according to another embodiment of the present disclosure.
FIG. 4B is a diagram illustrating an immersion cooling system according to still another embodiment of the present disclosure.
FIG. 5 is a flowchart for describing a method of controlling an immersion cooling system according to an embodiment of the present disclosure.
FIG. 6 is a flowchart illustrating a method of determining a coolant to be provided to the immersion cooling chamber as per FIG. 5.

### DETAILED DESCRIPTION

Hereinafter, embodiments or aspects will be described in detail with reference to the accompanying drawings. However, since various changes may be made in the embodiments or aspects, the scope of the patent disclosure is not limited or restricted by these embodiments or aspects. It should be understood that all modifications, equivalents, and alternatives for the embodiments or aspects are comprised in the scope of the present disclosure. For example, it is to be understood that the present disclosure may assume various alternative variations and step sequences, except where expressly specified to the contrary. It is also to be understood that the specific devices and processes illustrated in the attached drawings, and described in the following detailed description, are simply exemplary and non-limiting embodiments or aspects of the disclosed subject matter. Hence, specific dimensions and other physical characteristics related to the embodiments or aspects disclosed herein are not to be considered as limiting.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one". Furthermore, as used herein, the term "set" is intended to include one or more items (e.g., related items, unrelated items, a combination of related and unrelated items, and/or the like) and may be used interchangeably with "one or more" or "at least one". Where only one item is intended, the term "one" or similar language is used. Also, as used herein, the terms "comprise", "comprises", "comprising", "include", "includes", "including", "has", "have", "having", or the like are intended to be openended terms. Further, the phrase "based on" is intended to mean "based at least partially on" unless explicitly stated otherwise. In addition, a reference to an action being "based on" a condition may refer to the action being performed "in response to" the condition. For example, the phrases "based on" and "in response to" may, in some non-limiting embodiments or aspects, refer to a condition for automatically triggering an action (e.g., a specific operation of an electronic device, such as a computing device, a processor, and/or the like).

It will be understood that when a component is described as being "connected", "combined" or "coupled" to another component, the component may be directly connected or coupled to the another component, but it may be "connected", "combined" or "coupled" to the another component by an intervening other component that may be present.

Further, in describing the components of the embodiment or aspect, the meaning of "or" may mean each of the components, may mean two or more of the components, or may mean all of the components. For example, it should be understood that the expressions "a, b or c" represent any one of "a", "b", "c", "a and b", "a and c", "b and c", and "a, b and c".

Components comprised in one embodiment or aspect and components comprising common functions will be described using the same names in other embodiments or aspects. The description given in one embodiment or aspect may be applied to other embodiments or aspects, and therefore will not be described in detail within the overlapping range, unless there is a description opposite thereto.

The device and/or 'data' processed by the device may be expressed in terms of 'information". Here, the information may be used as a concept comprising the data.

In the present disclosure, a term "coolant" refers to a substance used within an immersion cooling chamber to absorb or transfer heat from a heat source, or to suppress fire. The coolant may also be named a cooling medium or a thermal management medium. The coolant may comprise at least one of a cooling fluid, an additive, or a mixture thereof. The cooling fluid may be used alone in the immersion cooling chamber as a dielectric fluid. The cooling fluid may comprise at least one of a mineral oil-based, fluorine-based, synthetic ester-based, silicone-based, or hydrocarbon-based fluid. The additive may be mixed with the cooling fluid or introduced alone into the immersion cooling chamber. The additive may be a substance that modifies physical and/or chemical properties when mixed with the cooling fluid. In this case, all components other than the cooling fluid may be interpreted as falling within the category of "additive." The additive may comprise, for example, a fire suppressant, a substance capable of extinguishing active radicals (e.g., hydrogen radicals, hydroxyl radicals, etc.), but is not limited thereto.

Disclosed herein is an immersion cooling system comprising (a) an immersion cooling chamber, (b) a plurality of reservoirs, (c) a flow path control device, and (d) a controller. The disclosed system overcomes current limitations by allowing the coolant in the immersion cooling chamber to be dynamically switched or supplemented based on real-time temperature readings and thereby enabling the system to respond to extreme heat generation and better prevent fires.

As described herein, during normal operation, the immersion cooling chamber can be filled with a cost-effective standard coolant. However, when a temperature sensor detects that the temperature has reached or exceeded a reference threshold (e.g., 80°C), the controller can send a command to the flow path control device to switch to another coolant or additive with properties suitable for higher-temperature cooling or fire suppression. The system can also scale to three or more reservoirs with multiple reference temperature thresholds for more granular control.

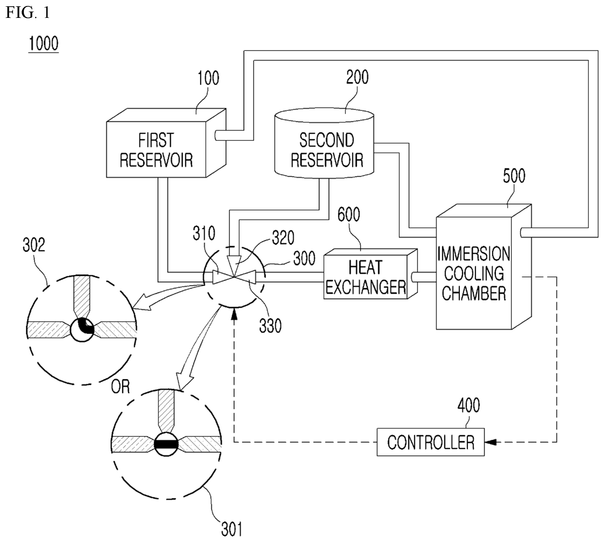

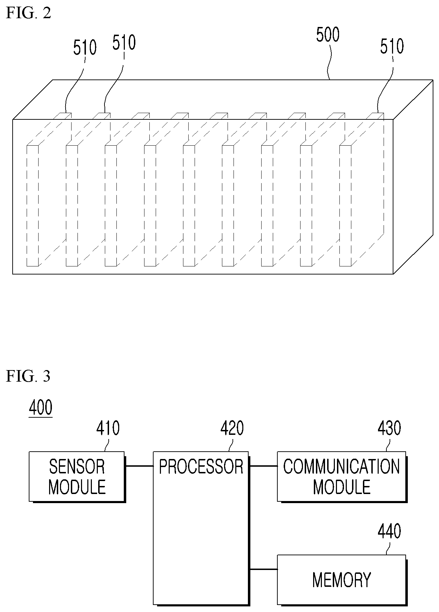

Accordingly, the disclosed systems provide improved safety, improved stability, and improved economic efficiency compared to conventional immersion cooling systems. FIG. 1 is a diagram illustrating an immersion cooling system 1000 according to an embodiment of the present disclosure, and FIG. 2 is a diagram illustrating the immersion cooling chamber 1000 of FIG. 1.

Referring to FIGS. 1 and 2, the immersion cooling system 1000 according to an embodiment of the present disclosure may include a first reservoir 100, a second reservoir 200, a flow path control device 300, a controller 400, an immersion cooling chamber 500, and a heat exchanger 600.

The first reservoir 100 may store a first coolant. The second reservoir 200 may store a second coolant different from the first coolant. According to an embodiment, the first coolant may include a first cooling fluid suitable for cooling below a predetermined reference temperature (e.g., 80° C). The first coolant may include a relatively inexpensive cooling fluid widely used in servers of data centers. The second coolant may include a second cooling fluid, a first additive or a combination thereof suitable for fire suppression. For example, the second coolant may include the second cooling fluid, the first additive, or the combination thereof capable of extinguishing activated radicals (e.g., hydrogen radicals, hydroxyl radicals, and the like). As another example, the first coolant may include, but is not limited to, a mineral oil, synthetic ester-based fluid, a hydrocarbon-based fluid, a silicone-based fluid, or a fluorocarbon-based fluid (e.g., a hydrofluoroether). The second coolant may comprise a cooling fluid, an additive, or a combination thereof, having fire suppression properties. When the second coolant comprises an additive, the additive may include at least one of a fluorinated compound, a halogenated compound, an inert gas, a phosphorus-based compound, a metal hydroxide, a metal oxide, a nitrogen-based compound, a boron-based compound, a silicone-based compound, an intumescent composition, a nanomaterial-based additive, an ionic liquid, a water-based suppressant, an aerosol-forming compound, a radical scavenger, an inorganic filler, a phase-change material, or combination thereof, but is not limited thereto. The specific coolants and additives described herein are exemplary and non-limiting, and any suitable thermal management material may be used. The first coolant and the second coolant may be different coolants. For example, the first coolant and the second coolant may have different properties (or characteristics, types). The second cooling fluid may contain the same base oil as the first cooling fluid or a different base oil. The first additive may be introduced into and mixed with the first coolant already filled in the liquid immersion cooling chamber 500 to supplement or adjust cooling performance, or to impart or improve fire suppression performance.

In some non-limiting embodiments, the first reservoir 100 and the second reservoir 200 may have the same (or similar) size or different sizes. For example, when the first reservoir 100 and the second reservoir 200 respectively store the first cooling fluid and the second cooling fluid, the first reservoir 100 and the second reservoir 200 may have the same or similar size. In this case, the sizes of the first reservoir 100 and the second reservoir 200 may correspond to the size of the immersion cooling chamber 500 (e.g., a size capable of accommodating the cooling fluid with which the immersion cooling chamber 500 is filled). As another example, when the first additive, rather than the second cooling fluid, is stored in the second reservoir 200, the second reservoir 200 storing the first additive may have a smaller size than the first reservoir 100 storing the first cooling fluid.

The flow path control device (e.g., valve assembly) 300 may be connected to the first reservoir 100 and the second reservoir 200. Under the control of the controller 400, the flow path control device 300 may control a flow path such that one of a plurality of reservoirs (e.g., the first reservoir 100 or the second reservoir 200) is connected to the immersion cooling chamber 500. The flow path control device 300 may include a multi-way valve (e.g., a three-way valve). For example, in the flow path control device 300, a first valve 310 may be connected to the first reservoir 100, a second valve 320 may be connected to the second reservoir 200, and a third valve 330 may be connected to the immersion cooling chamber 500. When the first coolant is provided to the immersion cooling chamber 500, the flow path control device 300 may open the first valve 310 and the third valve 330 and close the second valve 320 (see 301 in FIG. 1). When the second coolant is provided to the immersion cooling chamber 500, the flow path control device 300 may close the first valve 310 and open the second valve 320 and the third valve 330 (see 302 in FIG. 1).

The controller 400 may control the overall operation of the immersion cooling system 1000. The controller 400 may include, for example, a personal computer (PC), a laptop PC, a server or any other suitable computing device.

According to an embodiment, the controller 400 may receive a temperature of the immersion cooling chamber 500 or at least one heat source from at least one temperature sensor, determine, based on the received temperature, a coolant to be provided to the immersion cooling chamber 500, and control the flow path control device 300 such that the determined coolant is provided to the immersion cooling chamber 500. For example, the controller 400 may determine whether the received temperature is lower than a predetermined reference temperature (e.g., 80° C.), and may control the flow path control device 300 such that the first reservoir 100 is connected to the immersion cooling chamber 500 when the received temperature is lower than the reference temperature. On the other hand, the controller 400 may control the flow path control device 300 such that the second reservoir 200 is connected to the immersion cooling chamber 500 when the received temperature is equal to or greater than the reference temperature.

In some embodiments, the controller 400 may determine the coolant to be provided based not only on the absolute value of the received temperature but also on a rate of temperature change. For example, a rapid rate of temperature increase may indicate an imminent thermal event, and the controller 400 may proactively switch to the second coolant before the absolute temperature reaches the reference temperature. Additionally or alternatively, the controller 400 may apply hysteresis to temperature threshold comparisons to prevent rapid or repeated switching between coolants when the temperature fluctuates near a reference temperature.

The immersion cooling chamber (or immersion cooling tank) 500 may accommodate therein a coolant (e.g., a first coolant and/or a second coolant) and at least one heat source (or cooling target) (e.g., an electronic board 510). For example, as shown in FIG. 2, the immersion cooling chamber 500 may be filled with a cooling fluid, and at least one electronic board 510 may be immersed in the cooling fluid. The electronic board 510 may include at least one electronic component generating a large amount of heat (e.g., a central processing unit (CPU), a graphics processing unit (GPU), or the like). The at least one heat source accommodated in the immersion cooling chamber 500 may further include, but is not limited to, power electronics, power converters, transformers, application-specific integrated circuits (ASICs), or any other component or device that generates heat during operation.

In a normal state (or a default state), the immersion cooling chamber 500 may be filled with the first coolant(e.g., the first cooling fluid), and when the immersion cooling chamber 500 is in a designated state (e.g., when the temperature of the immersion cooling chamber 500 rises to or above a reference temperature (80° C.)), the second coolant (e.g., the second cooling fluid or an first additive) may be introduced into the immersion cooling chamber 500.

According to one embodiment, when the coolant supplied to the immersion cooling chamber 500 by the path control device 300 is switched from the first coolant to the second coolant, the first coolant remaining in the path (e.g., pipe) and/or within the immersion cooling chamber 500 prior to the switch may be mixed with the newly supplied second coolant. Even in this mixed state, there may be no substantial impediment to cooling performance and/or fire suppression performance. According to some embodiments, the residual coolant prior to the switch may be purged so that mixing does not occur.

The heat exchanger 600 may cool the first coolant (or the second coolant) below a designated temperature and provide the same to the immersion cooling chamber 500. The heat exchanger 600 may be located at a front end of the immersion cooling chamber 500. For example, the heat exchanger 600 may be located between the flow path control device 300 and the immersion cooling chamber 500. According to an embodiment, the heat exchanger 600 may be located between the first reservoir 100 and the flow path control device 300. Another heat exchanger may be further located between the second reservoir 200 and the flow path control device 300.

In some embodiments, the immersion cooling system 1000 may further include a return line configured to recover used coolant from the immersion cooling chamber 500 and return the used coolant to a corresponding reservoir or to a separate collection vessel. The return line may include a pump and, optionally, a filter or purifier for removing contaminants from the recovered coolant before it is returned to a reservoir for reuse. Such a configuration may reduce coolant waste and improve the overall cost efficiency of the system 1000.

Meanwhile, although FIG. 1 illustrates and describes that the immersion cooling system 1000 includes the first reservoir 100 and the second reservoir 200, the immersion cooling system 1000 may include three or more reservoirs. For example, the immersion cooling system 1000 may include first to third reservoirs respectively storing a first to third coolant. The first reservoir may include (or store) a first coolant (e.g., the first cooling fluid) suitable for cooling below a first reference temperature (e.g., 50° C). The second reservoir may include (or store) a second coolant suitable for cooling below a second reference temperature (e.g., 80° C.) greater than the first reference temperature. The second coolant may include a second cooling fluid, a first additive, or a combination thereof. In this case, the second cooling fluid may include the same base oil as the first cooling fluid or a different base oil. The first additive may supplement or improve cooling performance by being introduced and mixed with the first coolant already filled in the immersion cooling chamber 500. The third reservoir may include (or store) a third coolant suitable for cooling at or above the second reference temperature and/or for fire suppression. The third coolant may comprise a third cooling fluid, a second additive, or a combination thereof. In this case, the third cooling fluid may comprise the same base oil as the first cooling fluid and/or the second cooling fluid, or may comprise a different base oil. The second additive may impart or enhance fire suppression performance by being introduced and mixed into the existing coolant within the immersion cooling chamber 500. The first additive and the second additive may be the same or different.

FIG. 3 is a block diagram illustrating a configuration of a controller 400 according to an embodiment of the present disclosure.

Referring to FIGS. 1 and 3, the controller 400 according to an embodiment of the present disclosure may include a sensor module 410, a processor 420, a communication module 430, and a memory 440.

The sensor module 410 may detect (or measure) a temperature of the immersion cooling chamber 500 and provide (e.g., transmit) the detected temperature to the processor 420. The sensor module 410 may be located at at least one of an exterior of the immersion cooling chamber 500 and an interior of the immersion cooling chamber 500. According to an embodiment, at least one sensor module 410 may be respectively located on each electronic board 510. The sensor module 410 may include various types of temperature sensors.

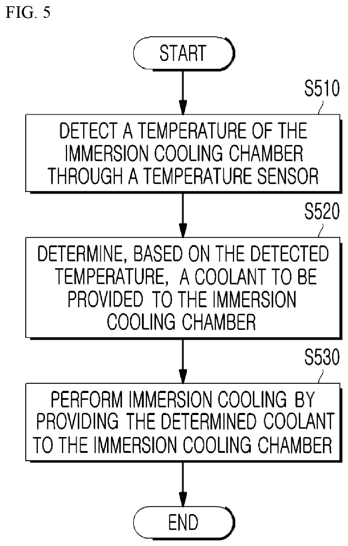

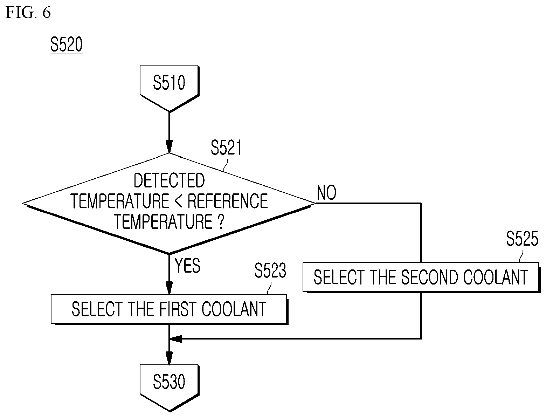

The processor 420 may control the overall operation of the controller 400. The processor 420 may receive the temperature of the immersion cooling chamber 500 from the sensor module 410, determine, based on the received temperature, a coolant to be provided to the immersion cooling chamber 500, and control the flow path control device 300 such that the determined coolant is provided to the immersion cooling chamber 500. Hereinafter, the coolant may be named the first coolant, the second coolant, the third coolant, etc., to indicate that they are different from one another. The processor 420 may generate a flow path control command (or valve control command) for controlling the flow path control device 300 such that one of the plurality of reservoirs 100 and 200 is connected to the immersion cooling chamber 500 based on a temperature obtained through at least one temperature sensor included in the sensor module 410. The determined coolant (e.g., a cooling fluid) may be cooled below a designated temperature by the heat exchanger 600 and then provided to the immersion cooling chamber 500. A detailed operation of the processor 420 will be described later with reference to FIGS. 5 and 6.

The communication module 430 may support wired communication or wireless communication. The communication module 430 may communicate with an external device. Under the control of the processor 420, the communication module 430 may transmit a flow path control command (e.g., a first command or a second command) to the flow path control device 300. For example, when the first coolant is to be provided to the immersion cooling chamber 500 (e.g., when the detected temperature is lower than the reference temperature), the communication module 430 may transmit, to the flow path control device 300, the first command for opening the first valve 310 and the third valve 330 and closing the second valve 320. When the second coolant is to be provided to the immersion cooling chamber 500 (e.g., when the detected temperature is equal to or greater than the reference temperature), the communication module 430 may transmit, to the flow path control device 300, the second command for closing the first valve 310 and opening the second valve 320 and the third valve 330. According to some embodiments, the communication module 430 may transmit a third command to the flow path control device 300 to open the first valve 310, the second valve 320, and the third valve 330 when the second coolant is to be supplied to the immersion cooling chamber 500. In other words, when the second coolant is to be supplied to the immersion cooling chamber 500 (e.g., when the detected temperature is equal to or greater than the reference temperature), the first coolant and the second coolant may be supplied together to the immersion cooling chamber 500.

The memory 440 may store various data used by at least one component of the controller 400. The data may include, for example, input data or output data for software and related instructions. The memory 440 may include a volatile memory (not shown) or a non-volatile memory (not shown). According to an embodiment, the memory 440 may store a program (e.g., software) for variably controlling the flow path of the flow path control device 300 based on the temperature of the immersion cooling chamber 500. According to an embodiment, the memory 440 may store at least one reference temperature for varying the flow path of the flow path control device 300. According to an embodiment, the memory 440 may store a mapping table including a plurality of reference temperatures for changing the coolant (or a reservoir). For example, when the immersion cooling system 1000 includes four coolants (e.g., four reservoirs), the mapping table may store a first reference temperature for switching a coolant flowing into the immersion cooling chamber 500 from a first coolant to a second coolant, a second reference temperature for switching from the second coolant to a third coolant, and a third reference temperature for switching from the third coolant to a fourth coolant.

Meanwhile, the sensor module 410 may not be included in the controller 400. For example, the sensor module 410 may be a separate component located in the immersion cooling chamber 500. In this case, the sensor module 410 may include a communication module for transmitting a measurement result (e.g., a temperature) to the controller 400. Alternatively, the sensor module 410 may be connected to another communication module located in the immersion cooling chamber 500, and may communicate with the communication module 430 of the controller 400 through the other communication module (e.g., may transmit the measured temperature).

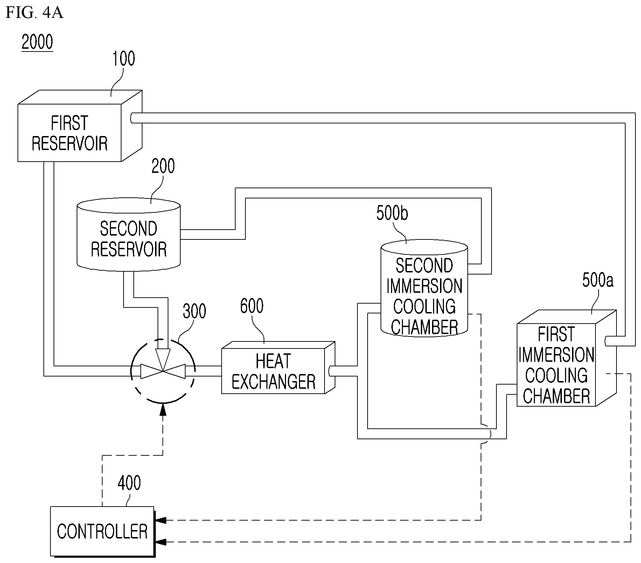

FIG. 4A is a diagram illustrating an immersion cooling system 2000 according to another embodiment of the present disclosure.

Referring to FIG. 4A, the immersion cooling system 2000 according to another embodiment of the present disclosure may include a plurality of immersion cooling chambers. The plurality of immersion cooling chambers may use the first reservoir 100 and the second reservoir 200 together (e.g., may share the first reservoir 100 and the second reservoir 200). Hereinafter, a case in which the immersion cooling system 2000 includes two immersion cooling chambers 500a and 500b will be described in detail by way of example.

According to an embodiment, the immersion cooling system 2000 may include the first reservoir 100, the second reservoir 200, the flow path control device 300, the controller 400, a first immersion cooling chamber 500a, a second immersion cooling chamber 500b, and the heat exchanger 600.

Since the first reservoir 100, the second reservoir 200, the flow path control device 300, and the heat exchanger 600 have been described above with reference to FIG. 1, detailed descriptions thereof will be omitted.

The controller 400 may respectively receive temperatures of the first immersion cooling chamber 500a (and/or a heat source included in the first immersion cooling chamber 500a) and the second immersion cooling chamber 500b (and/or a heat source included in the second immersion cooling chamber 500b) from sensor modules, and may control the flow path control device 300 based on the received temperatures. Since the controller 400 is similar to the controller 400 of FIG. 1, a detailed description thereof will be omitted.

The first immersion cooling chamber 500a may accommodate at least one first heat source (e.g., an electronic board) for cooling. The second immersion cooling chamber 500b may accommodate at least one second heat source (e.g., an electronic board) for cooling. Since the first immersion cooling chamber 500a and the second immersion cooling chamber 500b are similar to the immersion cooling chamber 500 of FIG. 1, detailed descriptions thereof will be omitted.

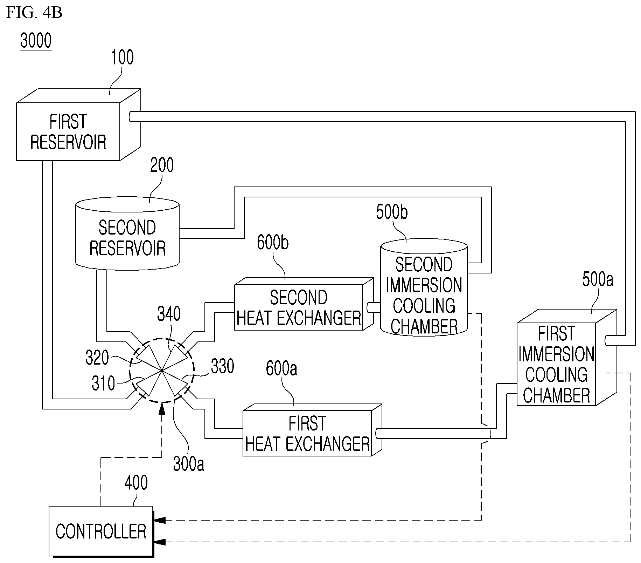

FIG. 4B is a diagram illustrating an immersion cooling system 3000 according to still another embodiment of the present disclosure.

Referring to FIG. 4B, the immersion cooling system 3000 according to still another embodiment of the present disclosure may include a first reservoir 100, a second reservoir 200, a flow path control device 300a, a controller 400, a first immersion cooling chamber 500a, a second immersion cooling chamber 500b, a first heat exchanger 600a, and a second heat exchanger 600b.

Under the control of the controller 400, the flow path control device 300a may control connections between the first reservoir 100 and the second reservoir 200 and the first heat exchanger 600a and the second heat exchanger 600b. The flow path control device 300a may include, but is not limited to, first to fourth valves 310, 320, 330, and 340.

The controller 400 may respectively receive temperatures of the first immersion cooling chamber 500a (and/or a heat source included in the first immersion cooling chamber 500a) and the second immersion cooling chamber 500b (and/or a heat source included in the second immersion cooling chamber 500b) from sensor modules, and may control the flow path control device 300a based on the received temperatures.

According to an embodiment, when the first coolant stored in the first reservoir 100 is to be provided to the first immersion cooling chamber 500a and the second immersion cooling chamber 500b through the first heat exchanger 600a and the second heat exchanger 600b, respectively, the controller 400 may open the first valve 310, the third valve 330, and the fourth valve 340, and may close the second valve 320. When the first coolant stored in the first reservoir 100 is to be provided to the second immersion cooling chamber 500b, the controller 400 may open the first valve 310 and the fourth valve 340, and may close the second valve 320 and the third valve 330. When the first coolant stored in the first reservoir 100 is to be provided to the first immersion cooling chamber 500a, the controller 400 may open the first valve 310 and the third valve 330, and may close the second valve 320 and the fourth valve 340.

According to an embodiment, when the second coolant stored in the second reservoir 200 is to be provided to the first immersion cooling chamber 500a and the second immersion cooling chamber 500b through the first heat exchanger 600a and the second heat exchanger 600b, respectively, the controller 400 may open the second valve 320, the third valve 330, and the fourth valve 340, and may close the first valve 310. According to some embodiment, the controller 400 may open all of the first valve 310 to the fourth valve 340 so that the second coolant stored in the second reservoir 200 is provided to the first immersion cooling chamber 500a and the second immersion cooling chamber 500b respectively, together with the first coolant stored in the first reservoir 100.

When the coolant having the second property stored in the second reservoir 200 is to be provided to the second immersion cooling chamber 500b, the controller 400 may open the second valve 320 and the fourth valve 340, and may close the first valve 310 and the third valve 330. According to some embodiment, the controller 400 may open the first valve 310, the second valve 320, and the fourth valve 340 so that the second coolant stored in the second reservoir 200 is provided to the second immersion cooling chamber 500b, together with the first coolant stored in the first reservoir 100.

When the coolant having the second property stored in the second reservoir 200 is to be provided to the first immersion cooling chamber 500a, the controller 400 may open the second valve 320 and the third valve 330, and may close the first valve 310 and the fourth valve 340. According to some embodiment, the controller 400 may open the first valve 310, the second valve 320, and the third valve 330 so that the second coolant stored in the second reservoir 200 is provided to the first immersion cooling chamber 500a, together with the first coolant stored in the first reservoir 100.

In the immersion cooling system 3000, when the coolants are switched by the flow path control device 300a, the existing coolant remaining in the path (e.g., pipe) prior to switching, the first immersion cooling chamber 500a and/or the second immersion cooling chamber 500b and the newly supplied coolant may be mixed, and there may be no substantial impediment to the cooling and/or fire suppression performance even in this mixed state. Since the immersion cooling system 3000 is similar to the immersion cooling system 2000 of FIG. 4A, detailed descriptions of other components will be omitted.

FIG. 5 is a flowchart for describing a method of controlling an immersion cooling system according to an embodiment of the present disclosure, and FIG. 6 is a flowchart illustrating a method of determining a coolant to be provided to the immersion cooling chamber of FIG. 5.

Before describing the control method in detail, the configuration of FIGS. 1 and 3 will hereinafter be taken as an example for describing the method of controlling the immersion cooling system 1000.

Referring to FIGS. 5 and 6, a method of controlling the immersion cooling system according to an embodiment of the present disclosure (hereinafter, referred to as a control method) may include detecting a temperature of the immersion cooling chamber through a temperature sensor in step S510. For example, the controller 400 (e.g., the processor 420) may detect, through at least one temperature sensor (e.g., at least one temperature sensor included in the sensor module 410), a temperature of the immersion cooling chamber 500 (or a heat source).

According to an embodiment, the control method may include determining, based on the detected temperature, a coolant to be provided to the immersion cooling chamber 500 in step S520. As illustrated in FIG. 6, step S520 may include determining whether the detected temperature is lower than a predetermined reference temperature in step S521, selecting the first coolant when the detected temperature is lower than the reference temperature in step S523, and selecting the second coolant when the detected temperature is equal to or greater than the reference temperature in step S525. For example, the controller 400 (e.g., the processor 420) may compare the detected temperature with a reference temperature stored in the memory 440, and may determine (or select) that the first coolant is to be provided to the immersion cooling chamber 500 when the detected temperature is lower than the reference temperature. On the other hand, the controller 400 (e.g., the processor 420) may determine (or select) that the second coolant is to be provided to the immersion cooling chamber 500 when the detected temperature is equal to or greater than the reference temperature.

According to an embodiment, step S520 may be a step of determining, based on the detected temperature while the immersion cooling chamber contains a first coolant (e.g., in a default state), whether to maintain the first coolant in the immersion cooling chamber 500 or to provide a second coolant different from the first coolant.

According to an embodiment, the control method may include performing immersion cooling by providing the determined coolant to the immersion cooling chamber 500 in step S530. Step S530 may include providing the determined coolant to the immersion cooling chamber 500 by controlling the flow path control device 300 configured to control a flow path between the immersion cooling chamber 500 and a plurality of reservoirs 100 and 200 respectively storing a coolant. The providing step may include generating a flow path control command for controlling the flow path control device 300 such that a reservoir storing the determined coolant among the plurality of reservoirs 100 and 200 is connected to the immersion cooling chamber 500, and transmitting the flow path control command to the flow path control device 300. For example, the controller 400 (e.g., the processor 420) may control the flow path control device 300 such that the first reservoir 100 storing the first coolant is connected to the immersion cooling chamber 500 when the detected temperature is lower than the reference temperature. The controller 400 may control the flow path control device 300 such that the second reservoir 200 storing the second coolant is connected to the immersion cooling chamber 500 when the detected temperature is equal to or greater than the reference temperature. According to some embodiments, the controller 400 may control the flow path control device 300 so that when the received temperature is equal to or greater than the reference temperature, the first reservoir 100 storing the first coolant (e.g., first cooling fluid) and the second reservoir 200 storing the second coolant (e.g., second cooling fluid or first additive) are connected to the immersion cooling chamber 500.

Meanwhile, steps S510 to S530 may be repeated until immersion cooling is stopped (e.g., until power is turned off or a cooling-stop command is detected).

In addition, although FIGS. 5 and 6 have been described based on an example in which the immersion cooling system includes one reference temperature, the immersion cooling system may include a plurality of reference temperatures. For example, when the immersion cooling system includes three reference temperatures, the immersion cooling system may include a first reservoir storing a first coolant, a second reservoir storing a second coolant, a third reservoir storing a third coolant, a fourth reservoir storing a fourth coolant, and a flow path control device (e.g., a five-way valve). In this case, the controller 400 may control the flow path control device 300 such that the first reservoir is connected to the immersion cooling chamber 500 when the detected temperature is lower than a first reference temperature, control the flow path control device 300 such that the second reservoir is connected to the immersion cooling chamber 500 when the detected temperature is equal to or greater than the first reference temperature and lower than a second reference temperature, control the flow path control device 300 such that the third reservoir is connected to the immersion cooling chamber 500 when the detected temperature is equal to or greater than the second reference temperature and lower than a third reference temperature, and control the flow path control device 300 such that the fourth reservoir is connected to the immersion cooling chamber 500 when the detected temperature is equal to or greater than the third reference temperature.

According to one embodiment, the coolant of the present disclosure, such as a first coolant, a second coolant, a third coolant, or a fourth coolant, may optionally further include one or more additional performance additives. The additional performance additives may include additives commonly used in the cooling field. For example, the additives may include, but are not limited to, antioxidants, corrosion inhibitors, seal regenerators, lubricating additives, flow improvers, flame retardants, smoke inhibitors, combustion inhibitors, metal deactivators, foaming inhibitors, seal swelling agents, or combinations thereof. Generally, the fully formulated coolant may include one or more of the performance additives described above. The fully formulated coolant may be included in a package form in which a plurality of performance additives are combined in optimal proportions.

The immersion cooling system of the present disclosure has been described above by taking, as an example, a case in which the heat source is an electronic board. However, the immersion cooling system of the present disclosure may also be applied to cooling various heat sources (e.g., a secondary battery). For example, the immersion cooling system of the present disclosure may be applied to cooling a secondary battery included in an electric vehicle (EV), an energy storage system (ESS), or the like.

Specifically, immersion cooling of a secondary battery immersed in the immersion cooling chamber may be performed using the first coolant, and when the temperature of the secondary battery (or the immersion cooling chamber) exceeds (or is equal to or greater than) a predetermined reference temperature while immersion cooling of the secondary battery is being performed (e.g., when it is determined that thermal runaway has occurred), the second coolant may be provided to the immersion cooling chamber. In this case, the controller may be a battery management system (BMS) or an electronic control unit (ECU) of an electric vehicle, or a battery management system (BMS) or an energy management system (EMS) of an energy storage system.

In addition to electronic boards and secondary batteries, the immersion cooling system of the present disclosure may be applied to a cooling of the electronic device itself, which generates heat, or at least some components constituting the electronic device. The electronic device may include any device that utilizes power and requires the dissipation of thermal energy to prevent overheating. For example, the electronic device may include, but is not limited to, an aircraft electronic device, an Uninterruptible Power Supply (UPS), power electronics in industrial equipment, transformer, cryptocurrency mining hardware, high-performance computing (HPC) clusters, telecommunications equipment, and medical imaging devices. The components constituting the electronic device may include power electronic devices (e.g., IGBT (Insulated Gate Bipolar Transistor), SCR (Silicon Controlled Rectifier), thyristor, capacitor, diode, transistor, rectifier, etc.), inverters (e.g., DC (Direct Current)-AC (Alternating Current) inverter, phase conversion inverter), converters (e.g., DC-DC converter, AC-DC converter), chargers, electric motors, electric motor controllers, etc.

The immersion cooling system according to the present disclosure may be applied without limitation to various heat-generating systems including the electronic device. The modular nature of the multi-reservoir architecture allows the system to be scaled and adapted to different thermal management requirements across a wide range of industries and applications.

According to an embodiment of the present disclosure, safety and/or stability of the immersion cooling system may be improved. For example, the safety and/or stability of the immersion cooling system may be improved by the coolant of the immersion cooling chamber may being switched to acoolant suitable for a designated condition (or situation).

According to an embodiment of the present disclosure, economic efficiency of the immersion cooling system may be improved. For example, in a normal state (e.g., normal operation), the immersion cooling system may provide the relatively inexpensive the first coolant to the immersion cooling chamber, and may provide the relatively expensive the second coolant to the immersion cooling chamber in a designated state (or situation) (e.g., when a risk of fire is detected). Since the immersion cooling systems of the present disclosure provide the expensive coolant to the immersion cooling chamber only when needed and do not require a separate fire-prevention device, operating costs, maintenance costs, and the like may be reduced.

The contents described above are merely examples applying the principles of the present disclosure, and other configurations may be further included without departing from the scope of the present invention. For example, at least some of the various embodiments of the present disclosure described above may be combined.

## Claims

1. An immersion cooling system (1000, 2000, 3000) comprising:
an immersion cooling chamber (500, 500a, 500b) configured to accommodate at least one first heat source;
a plurality of reservoirs (100, 200) configured to respectively store a coolant;
a flow path control device (300, 300a) connected to the plurality of reservoirs (100, 200) and configured to control a flow path such that a coolant stored in one of the plurality of reservoirs (100, 200) is provided to the immersion cooling chamber (500, 500a, 500b); and
a controller (400) configured to receive, from at least one temperature sensor, a temperature of the immersion cooling chamber (500, 500a, 500b) or the at least one first heat source, determine, based on the received temperature, a coolant to be provided to the immersion cooling chamber (500, 500a, 500b), and control the flow path control device (300, 300a) such that the determined coolant is provided to the immersion cooling chamber (500, 500a, 500b).

2. The immersion cooling system (1000, 2000, 3000) of claim 1, wherein the plurality of reservoirs (100, 200) comprise:
a first reservoir (100) configured to store a first coolant; and
a second reservoir (200) configured to store a second coolant different from the first coolant.

3. The immersion cooling system (1000, 2000, 3000) of claim 2, wherein the controller (400) is configured to:
determine whether the received temperature is lower than a predetermined reference temperature;
control the flow path control device (300, 300a) such that the first reservoir (100) is connected to the immersion cooling chamber (500, 500a, 500b) when the received temperature is lower than the reference temperature; and
control the flow path control device (300, 300a) such that the second reservoir (200) is connected to the immersion cooling chamber (500, 500a, 500b) when the received temperature is equal to or greater than the reference temperature.

4. The immersion cooling system (1000, 2000, 3000) of claim 3, wherein the first coolant comprises a cooling fluid suitable for cooling below the reference temperature, and the second coolant comprises a cooling fluid or an additive suitable for cooling at or above the reference temperature or for fire suppression.

5. The immersion cooling system (1000, 2000, 3000) according to any one of claims 2 to 4, wherein the plurality of reservoirs (100, 200) further comprise a third reservoir configured to store a third coolant different from the first coolant and the second coolant, wherein the first coolant comprises a cooling fluid suitable for cooling below a predetermined first reference temperature, the second coolant comprises a cooling fluid or an additive suitable for cooling below a second reference temperature greater than the first reference temperature, and the third coolant comprises a cooling fluid or an additive suitable for cooling at or above the second reference temperature or for fire suppression.

6. The immersion cooling system (1000, 2000, 3000) according to any one of claims 1 to 5, wherein the at least one temperature sensor is located at at least one of an exterior of the immersion cooling chamber (500, 500a, 500b) and an interior of the immersion cooling chamber (500, 500a, 500b).

7. The immersion cooling system (1000, 2000, 3000) according to any one of claims 1 to 6, wherein the flow path control device (300, 300a) comprises a multi-way valve.

8. The immersion cooling system (1000, 2000, 3000) according to any one of claims 1 to 7, further comprising a heat exchanger (600, 600a, 600b) located between the flow path control device (300, 300a) and the immersion cooling chamber (500, 500a, 500b) and configured to cool a coolant provided to the immersion cooling chamber (500, 500a, 500b).

9. The immersion cooling system (1000, 2000, 3000) according to any one of claims 1 to 8, wherein the at least one first heat source comprises at least one of an electronic board (510) including at least one electronic component, an electronic device, or a secondary battery.

10. The immersion cooling system (2000, 3000) according to any one of claims 1 to 9, further comprising at least one additional immersion cooling chamber (500a, 500b) configured to accommodate at least one second heat source and share the plurality of reservoirs (100, 200) with the immersion cooling chamber (500a, 500b).

11. A method for controlling an immersion cooling system (1000, 2000, 3000), the method comprising:
detecting, through at least one temperature sensor heat source, a temperature of an immersion cooling chamber (500, 500a, 500b) or at least one heat source (S510) included in the immersion cooling chamber (500, 500a, 500b);
determining, based on the detected temperature, a coolant to be provided to the immersion cooling chamber (500, 500a, 500b) (S520); and
performing immersion cooling by providing the determined coolant to the immersion cooling chamber (500, 500a, 500b) (S530).

12. The method of claim 11, wherein performing the immersion cooling comprises providing, to the immersion cooling chamber (500, 500a, 500b), the determined coolant by controlling a flow path control device (300, 300a) configured to control a flow path between the immersion cooling chamber (500, 500a, 500b) and a plurality of reservoirs (100, 200) configured to respectively store a coolant.

13. The method of claim 11 or 12, wherein determining the coolant comprises determining, based on the detected temperature while the immersion cooling chamber (500, 500a, 500b) contains the first coolant, whether to maintain provision of the first coolant in the immersion cooling chamber (500, 500a, 500b) or to provide, to the immersion cooling chamber (500, 500a, 500b), a second coolant different from the first coolant.

14. The method of claim 13, wherein determining the coolant comprises:
determining whether the detected temperature is lower than a predetermined reference temperature (S521);
selecting the first coolant when the detected temperature is lower than the reference temperature (S523); and
selecting the second coolant when the detected temperature is equal to or greater than the reference temperature (S525).

15. The method according to any one of claims 12 to 14, wherein performing the immersion cooling comprises:
controlling the flow path control device (300, 300a) such that a first reservoir (100) configured to store the first coolant is connected to the immersion cooling chamber (500, 500a, 500b) when the detected temperature is lower than a predetermined reference temperature; and
controlling the flow path control device (300, 300a) such that a second reservoir (200) configured to store the second coolant is connected to the immersion cooling chamber (500, 500a, 500b) when the detected temperature is equal to or greater than the reference temperature.
